Europäisches Patentamt

European Patent Office

Office européen des brevets

(11) Publication number: **0 064 264**
**B1**

(12) # EUROPEAN PATENT SPECIFICATION

(45) Date of publication of patent specification: **20.07.88**

(51) Int. Cl.⁴: **C 04 B 35/56**, H 01 B 3/12, H 01 L 23/14

(21) Application number: **82103585.4**

(22) Date of filing: **27.04.82**

(54) **Silicon carbide powder mixture and process for producing sintered bodies therefrom.**

(30) Priority: **30.04.81 JP 64157/81**

(43) Date of publication of application:
**10.11.82 Bulletin 82/45**

(45) Publication of the grant of the patent:
**20.07.88 Bulletin 88/29**

(84) Designated Contracting States:
**DE FR GB NL**

(56) References cited:
**EP-A-0 028 802**
**GB-A-2 011 879**
**US-A-4 023 975**
**US-A-4 172 109**

**CHEMICAL ABSTRACTS, volume 94, no. 8,
February 1981, page 291, abstract 51821s
(COLUMBUS, OHIO, US) & JP - A - 80 085 469
(HITACHI LTD.) 27-06-1980**

**The file contains technical information
submitted after the application was filed and
not included in this specification**

(73) Proprietor: **Hitachi, Ltd.**
**5-1, Marunouchi 1-chome
Chiyoda-ku Tokyo 100 (JP)**

(72) Inventor: **Ogihara, Satoru**
**822, Minamikoyacho
Hitachi-shi (JP)**
Inventor: **Nakamura, Kosuke**
**2460, Tateno Kujicho
Hitachi-shi (JP)**
Inventor: **Takeda, Yukio**
**7-21- Osecho-4-chome
Hitachi-shi (JP)**
Inventor: **Matsushita, Yasuo**
**60-10, Ishinazakacho
Hitachi-shi (JP)**
Inventor: **Asai, Tadamichi**
**11-1, Minamidai Suwama Tokaimura
Naka-gun Ibaraki-ken (JP)**
Inventor: **Okoshi, Tokio**
**10-12, Suehirocho-3-chome
Hitachi-shi (JP)**

(74) Representative: **von Füner, Alexander, Dr. et al
Patentanwälte v. Füner, Ebbinghaus, Finck
Mariahilfplatz 2 & 3
D-8000 München 90 (DE)**

Courier Press, Leamington Spa, England.

## Description

This invention relates to a mixture for producing sintered bodies having high electrical resistivity and a process for producing such sintered bodies.

With advanced densification of electronic circuits in recent years, requests are growing for an insulating substrate for mounting semiconductor elements which substrate has good heat transfer properties for allowing efficient dissipation of heat generated by the semiconductor elements and which also has a thermal expansion coefficient equal to that of the semiconductor elements. Alumina sintered bodies have been popularly used as an insulating substrate material, but such alumina substrates have some serious disadvantages such as poor heat dissipativity and a high thermal expansion coefficient, which is around $80 \times 10^{-7}/°C$, in comparison with silicon whose thermal expansion coefficient is on the order of $35—40 \times 10^{-7}/.674C$. Therefore, alumina sintered bodies need be improved for their wider utilisation to have (1) better heat dissipativity, (2) higher insulating characteristics and (3) a lower thermal expansion co-efficient approximate to that of silicon.

Silicon carbide sintered bodies have a thermal expansion coefficient of around $40 \times 10^{-7}/°C$ which is lower than that of alumina and approximate to that of silicon, and it is also known that their heat conductivity is as high as $41.8—83.6$ W/m·K which is three times or more larger than that of alumina. However, silicon carbide is a material well known as a semiconductor and little known as an insulating material.

In the European Patent 0 028 802 there is described an electrically insulating substrate and a method of making such a substrate whereby from 0.1 to 3.5% by weight of beryllium oxide powder, calculated as beryllium, are added to silicon carbide powder containing up to 0.1% by weight of aluminum, up to 0.1% by weight of boron and up to 0.4% by weight of free carbon, and the mixed powder is pressure-molded. The resulting molded article is heated to a temperature of 1,850°C to 2,500°C till there is obtained a sintered body having at least 90% relative density of silicon carbide. Thus, the sintered body having a thermal conductivity of at least 1.67 J/cm.sec.°C at 25°C, an electrical resistivity of at least $10^7$ Ohm.cm at 25°C and a coefficient of thermal expansion of $3.3 \sim 4 \times 10^{-6}/°C$ at 25°C to 300°C can be obtained. There is only the disclosure that the incorporation of berryllium is in the form of BeO or metallic BeO as the starting material. In case BeO is added there is observed a deviation of electrical resistivity as shown in Table 4 (Example 6) below.

The present inventors have investigated insulating substrates using silicon carbide as insulator. Some substrates, however, had a disadvantage in that their heat conductivity cannot be raised above 41.8 W/m·K owing to unavailability of a sintering aid having good heat conductivity, said sintering aid being mixed when producing a silicon carbide sintered body for the purpose of bettering electrical insulating quality, which results in not meeting both requirements of high heat conductivity and excellent electrical insulating properties at the same time.

The present invention has for its object to provide a mixture for producing electrically insulating silicon carbide sintered bodies and a process for producing such sintered bodies.

This invention provides a mixture for producing an electrically insulating silicon carbide sintered body, characterized by comprising silicon carbide containing 0.4% by weight or less of free carbon and 0.1% by weight or less of aluminum as impurities as a major component and at least one beryllium compound selected from the group consisting of $Be(OH)_2$, $Be(NO_3)_2$, $BeSO_4$, $BeSO_4 \cdot 2NH_3$, $BeCO_3$, $Be(HCO_2)_2$, $Be_4O(HCO_2)_6$, $BeC_2H_4$, $Be_4O(CH_3CO \cdot BeO_6$, $(NH_4)_2O \cdot 2_2O_3$, $(NH_4(_2Be(SO_4)_2$, and $Be(CH_3COCHCOCH_3)_2$ which can be converted to beryllium, beryllium oxide, beryllium carbide or beryllium nitride by decomposition with heating.

This invention also provides a process for producing an electrically insulating solicon carbide sintered body, characterized by preparing a mixture comprising silicon carbode containing 0.4% by weight or less of free carbon and 0.1% by weight or less of aluminium as impurities as a major component and at least one beryllium compound selected from the group consisting of $Be(OH)_2$, $Be(NO_3)_2$, $BeSO_4$, $BeSO_4 \cdot 2NH_3$, $BeCO_3$, $Be(HCO_2)_2$, $Be_4O(HCO_2)_6$, $BeC_2H_4$, $Be_4O(CH_3CO_2)_6$, $(NH_4)_2O \cdot BeO \cdot 2C_2O_3$, $(NH_4)_2Be(SO_4)_2$, and $Be(CH_3COCHCOCH_3)_2$ which can be converted to beryllium, beryllium oxide, beryllium carbide or beryllium nitride by decomposition with heating, shaping said mixture into a green product under pressure, and sintering said green product.

According to this invention, there can easily be obtained sintered bodies having, as measured at room temperature, a heat conductivity of 167.4 W/m·K or higher, an electrical resistivity of $10^7$ Ω-cm or higher and a density of 90 percent or higher of the theoretical.

As the silicon carbide which is used as the principal component in this invention, there can be used silicon carbide powder which is α-silicon carbide and generally used as abrasives. Usually, it is recommended to use the silicon carbide powder of smaller particle size, with as grain number above #3,000 applied for abrasives, because the smaller the particle size, the easier is the powder to sinter, but use of the powder of greater particle size is not excluded from the scope of this invention if such powder is sinterable in the process of this invention. The powder with an average particle size of 10 μm or less, preferably 2 μm or less, is desirable. It is also possible to use β-silicon carbide in place of α-silicon carbide as a part of it or as a whole.

The beryllium compounds used in this invention are preferably those which are decomposed into beryllium, beryllium oxide, beryllium carbide or beryllium nitride upon heating at a temperature of 1950°C or lower, more preferably 1000°C or lower.

The amount of the beryllium compound or compounds to be added to the silicon carbide powder is preferably within the range of 0.05 to 7.5% by weight in terms of the amount of beryllium based on the amount of silicon carbide. The use of less than 0.05% by weight of the beryllium compound is found to retard sintering and makes it difficult to obtain a density in excess of 90%. It is therefore hardly possible with such amount of beryllium to produce a sintered body having good heat transfer properties and high strength. On the other hand, the use of beryllium compound in an amount excess of 7.5% by weight results in producing a product having a thermal expansion coefficient greater than $40 \times 10^{-7}$/°C which is undesirable in use if the product as an insulating substrate for silicon semi-conductors. The heat conductivity of the product also becomes lower than 167.4 W/m·K.

The beryllium compounds used may contain crystal water. Also, these beryllium compounds may be used either singly or in admixture of two or more of them.

For example, $BeSO_4$ is pyrolyzed at 1100°C to yield BeO, and thus it can be used in this invention. On the other hand, beryllium compounds which are not pyrolyzed but vaporized such as $BeCl_2$, etc., are not usable in this invention. It is important in this invention that all beryllium compounds usable in this invention are soluble (or well-dispersible) in a solvent. Therefore, the beryllium compounds can be mixed with silicon carbide (SiC) powder uniformly by using the beryllium compounds in the form of a solution. For example, a solution of beryllium compound is mixed with silicon carbide powder to give a slurry, which is, then for example, spray dried to remove the solvent to give a raw material powder wherein the beryllium compound and silicon carbide are mixed in uniform quality. As the solvent for dissolving the beryllium compounds, there can be used water, an organic solvent such as ethanol, acetone, ether, benzene, ethylenediamine, dilute acetic acid etc., an aqueous solution of inorganic material such as nitric acid, hydrochloric acid, etc., depending on the kind of beryllium compounds used. Preferable combinations of solvents and the beryllium compounds are ethylenediamine or an aqueous solution of nitric acid or hydrochloric acid for $Be(OH)_2$; water or ethanol for $Be(NO_3)_2$; an aqueous solution of nitric acid or hydrochloric acid or dilute acetic acid for $BeCO_3 \cdot 4H_2O$; acetone or benzene for $Be_4O(CH_3CO_{26}$; ethanol, ether or benzene for $Be(CH_3COCHCOCH_3)_2$; water for $Be(HCO_2)_2$; acetone or benzene for $Be_4O(HCO_2)_6$; and aqueous solution of hydrochloric acid for $BeSO_4$, etc.

According to this invention, the particle size of beryllium compounds can be reduced remarkably. Thus, the sintering temperature can be lowered and a sintered body having higher density can easily be obtained. Further, since the mixture of beryllium compound and silicon carbide can be dispersed uniformly, the resulting sintered body has properties in uniform quality, particularly with slight deviations in specific resistance. Such outstanding properties cannot be expected when beryllium oxide powder is used in place of the beryllium compound used in this invention.

In addition, since the presence of free carbon in an amount of 4% by weight or more in the sintered body remarkably lowers electrical insulating properties, a binder comprising an organic resin containing a metal which can react with carbon should be used. As the organic resin, a silicone resin is preferable. The silicone resin is preferably used by being diluted with an organic solvent.

Further, the beryllium compounds used in this invention are those which are decomposed or reacted at a temperature below 1,950°C, because the silicon carbide powder is sintered when exposed to a temperature above 1,950°C. If the beryllium compound used is pyrolyzed at a temperature above the sintering starting temperature, the resulting sintered body becomes porous due to the gas produced by the pyrolysis, and thus it is impossible to obtain a sintered body with a high density and compactness. A low density leads to not only low strength of the sintered body but also poor heat transfer properties thereof.

The mixture of silicon carbide and at least one special beryllium compound can be prepared by simply mixing these components in dry state by using a conventional technique, or by mixing a solution of special beryllium compound with silicon carbide powder to give a slurry and spray drying the resulting slurry as mentioned above, or by other conventional method.

The mixture is, then, shaped into a green product under pressure by using a conventional method.

The sintering conditions for the beryllium compound-containing silicon carbide powder are also important. Sintering is preferably conducted in a nonpoxidative atmosphere. In an oxidized atmosphere, the silicon carbide powder is oxidized at its surface and a high-density sintered body can hardly be obtained. Also, there is available no furnace material which can stand use in an oxidative atmosphere at an elevated sintering temperature above 1,800°C. For these reasons, it is possible to oxidatively decompose the beryllium compound by heating the powder mixture or the green product thereof at a temperature of 1,000°C or lower and in which there takes place no oxidation of the silicon carbide powder.

The sintering temperature used in this invention should be within the range of 1.850° to 2,500°C, preferably 1,900° to 2,300°C. Use of the temperature below 1,850°C makes it difficult to obtain a high-density sintered body and also results in a poor heat transfer quality of the product. On the other hand, use of a temperature above 2,500°C invites excess sublimation of silicon carbide, making it hardly possible to obtain a compact sintered body.

When hot pressing is employed for pressing the specimen during sintering, the upper limit of the pressure loading depends on the die material used. Usually, graphite-made dies are preferably used. In the case of graphite-made dies, the pressure may be applied to a maximum of about 68.6 MPa.

Usually, however, a high-density sintered body can also be obtained without applying any pressure. It is possible to produce a dense sintered body with no pressure application by using silicon carbide powder of submicron size.

The optimum sintering time is decided according to various conditions involved in the operation such as the particle size of the powder mixture, the temperature and pressure applied during the sintering. Generally, the smaller the particle size of the powder used and the higher the sintering temperature and also the higher the pressure applied, the shorter time is required for attaining desired densification.

No definite disclosure has yet been made of the mechanism that gives a highly heat-conductive and insulating sintered body from sintering of a silicon carbide powder containing a beryllium compound, but the following qualitative explanation seems to be persuasive. Silicon carbide is a covalent bonding material like diamond or beryllia. In these materials, unlike in metals, heat is transferred not by electronic conduction but by means of phonons through lattice vibration, and hence these materials have good heat transfer properties although they have insulating characteistics. The high-purity single crystals of silicon carbide are insulating and also have a heat conductivity of as high as 418.4 W/m·K. However, for the reasons that in the case of ordinary sintered bodies there can hardly be obtained those having a heat conductivity of 167.4 W/m·K as their heat transfer properties are adversely affected by scattering of phonons at grain boundaries or by impingement of the impurity elements entrapped in the silicon particles against phonons, that when aluminum or such is entrapped in silicon carbide, there is formed a P type semiconductor to elevate the electric conductivity, making it impossible to obtain a sintered body having an electric insulation resistance of $10^7$ Ω-cm or higher, that beryllium, even when sintered with silicon carbide, causes no increase of carrier which is an electrical conductivity elevating factor, and that scattering of phonons by beryllium considered to exist at the grain boundaries is limited and resistance is increased by the formation of barriers at grain boundaries, it is considered that the beryllium-containing sintered body has better heat transfer properties and more excellent electrical insulating properties than the ordinary silicon carbide sintered bodies. Also, beryllium serves as a sintering aid for silicon carbide and thus conduces to the formation of a dense sintered body. The sintered body with a low density cannot provide a sintered product with high heat conductivity as heat transfer is impaired by the pores therein. Thus, beryllium functions to assist sintering of silicon carbide and also proves beneficial for bettering the electrical insulating properties and not causing a reduction of heat conductivity of the produced sintered body. Therefore, beryllium added needs to be dispersed uniformly in the silicon carbide powder used as the principal component. By addition of a beryllium compound (or compounds) which is heat-decomposed into beryllium, beryllium oxide, beryllium carbide or beryllium nitride, as compared with the case of mixing beryllium in the form of metallic beryllium or beryllium oxide in the silicon carbide powder, sintering of silicone carbide is more expedited owing to the fine powder produced by the decomposition or active beryllium or beryllium oxide just after the decomposition. The present invention embraces within its scope the use of the starting powder mixture which contains not only a heat-decomposable beryllium compound or compounds but also a small quantity of elemental beryllium, beryllium oxide, beryllium carbide and/or beryllium nitride. Further, it should be noted that a sintered body having high electrical insulating properties can only be obtained by using SiC powder containing as an impurities 0.4% by weight or less of free carbon and 0.1% by weight of Al, or by making the free carbon content in the sintered body 0.4% by weight or less derived from a binder.

## Example 1

Beryllium hydroxide Be(OH)$_2$ was mixed in amounts ranging from 0.14 to 72% by weight (0.03 to 15% in terms of Be basis) in silicon carbide powder with an average particle size of 2 μm to prepare various powder mixtures as shown in Table 1. Then the powder mixtures were molded under a pressure of 98.0 MPa. The moldings had powder densities ranging from 1.60 to 1.67 g/cm$^3$ (relative density corresponding to 50 to 52% of the theoretical of silicon carbide). Each molding was placed in a graphite die and hot pressed in vacuo ($1.33 \times 10^{-3}$ to $1.33 \times 10^{-1}$ Pa) to obtain a sintered body. The pressure of 29.4 MPa was applied at room temperature. Heating was made from room temperature to 2,000°C in about 2 hours, and after one hour hold at 2,000°C, the heating power source was cut off to effect cooling. The pressure was released after the temperature dropped below 1,500°C. The relation between the properties of the thus produced silicon carbide sintered bodies and the beryllium content is shown in Table 1. Impurities in the starting SiC powder were B 17 ppm., Mg 17 ppm, Al 87 ppm, Ca 51 ppm, Ti 1290 ppm, V 540 ppm, Cr 150 ppm, Mn 7 ppm, Fe 650 ppm, Co 11 ppm, Ni 240 ppm, Zn 1 ppm, Na 90 ppm, free Si 0.57 wt.%, free C 0.08 wt.% and SiO$_2$ 1.4 wt.%.

| Run No. | Amount of Be (%) | Relative density (%) | Heat conductivity (W/m·K) | Electrical resistivity (Ω-cm) | Coefficient of thermal expansion $10^{-6}$/°C |
|---|---|---|---|---|---|
| 1 | 0.03 | 91 | 62.7 | $10^{12}$ | 3.3 |
| 2 | 0.05 | 97 | 167.4 | $10^{12}$ | 3.3 |
| 3 | 0.1 | 98 | 251.0 | $10^{13}$ | 3.3 |
| 4 | 0.2 | 98 | 272.0 | $>10^{13}$ | 3.3 |
| 5 | 0.5 | 99 | 272.0 | $>10^{13}$ | 3.3 |
| 6 | 1.0 | 99 | 272.0 | $>10^{13}$ | 3.3 |
| 7 | 2.0 | 99 | 272.0 | $>10^{13}$ | 3.3 |
| 8 | 3.0 | 99 | 251.0 | $>10^{13}$ | 3.4 |
| 9 | 5.0 | 99 | 230.1 | $>10^{13}$ | 3.5 |
| 10 | 7.0 | 99 | 209.2 | $>10^{13}$ | 3.7 |
| 11 | 7.5 | 99 | 209.2 | $>10^{13}$ | 3.9 |
| 12 | 10.0 | 99 | 188.3 | $>10^{13}$ | 4.2 |
| 13 | 15.0 | 99 | 167.4 | $>10^{13}$ | 4.5 |

The products, with the amounts of beryllium used being 0.05 to 7.5% by weight, showed a heat conductivity 167.4 W/m·K or more, an electrical resistivity of $10^{12}$ Ω-cm or more and a thermal expansion coefficient of $3.3—3.9\times10^{-6}$/°C.

Example 2

Beryllium nitrate (Be(No$_3$)$_2$) was added in amounts ranging from 0.44 to 150% by weight (0.03 to 10% by weight in terms of Be) to the same silicon carbide powder as used in Example 1, and each mixture was added with a 10% by weight of xylene solution containing 25% by weight of silicone resin as binder for molding and mixed in a mixing and grinding machine with stirring. The mixtures were molded and hot pressed in the same way as in Example 1 to obtain sintered bodies. The hot pressing conditions and the properties of the obtained sintered bodies are shown in Table 2.

Table 2

| Run No. | Amount of Be (%) | Hot pressing conditions | | Time (hr) | Relative density (%) | Heat conductivity (W/m·K) | Resistivity (Ω-cm) | Coefficient of thermal expansion ($10^{-6}$/°C) |
|---|---|---|---|---|---|---|---|---|
| | | Temperature (°C) | Pressure (MPa) | | | | | |
| 1 | 0.03 | 2000 | 29.4 | 1 | 85 | 125.5 | $10^{13}$ | 3.3 |
| 2 | 0.05 | 2000 | 29.4 | 1 | 95 | 175.7 | $10^{13}$ | 3.3 |
| 3 | 0.15 | 1900 | 29.4 | 1 | 98 | 272.0 | $>10^{13}$ | 3.3 |
| 4 | 1.0 | 1800 | 29.4 | 1 | 80 | 83.6 | $>10^{13}$ | 3.3 |
| 5 | 1.0 | 1900 | 29.4 | 1 | 96 | 209.2 | $>10^{13}$ | 3.3 |
| 6 | 1.0 | 2000 | 19.6 | 1 | 99 | 280.3 | $>10^{13}$ | 3.3 |
| 7 | 2.0 | 1800 | 29.4 | 1 | 85 | 125.5 | $>10^{13}$ | 3.3 |
| 8 | 2.0 | 1900 | 29.4 | 0.5 | 97 | 251.0 | $>10^{13}$ | 3.4 |
| 9 | 2.0 | 2100 | 29.4 | 0.5 | 99 | 280.3 | $>10^{13}$ | 3.4 |
| 10 | 2.0 | 2300 | 29.4 | 1 | 99 | 272.0 | $10^{13}$ | 3.4 |
| 11 | 5.0 | 2100 | 29.4 | 1 | 99 | 251.0 | $>10^{13}$ | 3.7 |
| 12 | 10.0 | 2100 | 29.4 | 1 | 99 | 146.4 | $>10^{13}$ | 4.2 |
| 13 | 10.0 | 1800 | 29.4 | 1 | 80 | 125.5 | $>10^{13}$ | 4.2 |

Addition of beryllium in amounts ranging from 0.05 to 5% by weight provided the silicon carbide sintered bodies having a heat conductivity of 167.4 W/m·K, an electrical resistivity of $10^{13}$ Ω-cm and a thermal expansion coefficient of $3.3$—$4.0 \times 10^{-6}/°C$. However, at the sintering temperature of 1,800°C, the relative density of the sintered body was below 90% and hence there could not be obtained the sintered body with desired heat conductivity.

### Example 3

Beryllium sulfate ($BeSO_4$), beryllium oxalate and other beryllium compounds were added respectively as shown in Table 3 to the same silicon carbide powder as used in Example 1 of 0.5—10 μm particle size, and the mixtures were molded and sintered in the same manner as described in Example 1 to obtain sintered bodies. The amounts of the beryllium compounds added (the amounts being determined in terms of beryllium) and the properties of the produced silicon carbide sintered bodies are shown in Table 3. Addition of two or more beryllium compounds could provide the silicon carbide sintered bodies having a heat conductivity above 167.4 W/m·K, an electrical resistivity of $10^{13}$ Ω-cm and a thermal expansion coefficient of $3.3$—$4.0 \times 10^{-6}/°C$.

Table 3

| Run No. | Amount of Be added | | | | Relative density (%) | Heat conductivity (W/m·K) | Electrical resistivity (Ω−cm) | Coefficient of thermal expansion ($10^{-6}$/°C) |
|---|---|---|---|---|---|---|---|---|
| | Compound | Amount (%) | Compound | Amount (%) | | | | |
| 1 | $BeSO_4$ | 0.5 | $Be(HCO_2)_2$ | 0.5 | 99 | 251.0 | $10^{13}$ | 3.4 |
| 2 | $BeSO_4$ | 1.0 | $BeC_2H_4$ | 0.5 | 98 | 263.6 | $>10^{13}$ | 3.4 |
| 3 | $Be_4O(HCO_2)_6$ | 0.5 | $BeC_2H_4$ | 0.5 | 98 | 251.0 | $>10^{13}$ | 3.4 |
| 4 | $BeH_4(PO_4)_2$ | 1.0 | $Be_4O(CH_3CO_2)_6$ | 0.5 | 99 | 263.6 | $>10^{13}$ | 3.4 |
| 5 | $BeHPO_4$ | 1.0 | $(NH_4)_2O \cdot BeO \cdot 2C_2O_3$ | 0.5 | 98 | 230.1 | $10^{13}$ | 3.5 |
| 6 | $Be_2P_2O_7$ | 0.5 | $Be_3N_2$ | 0.5 | 99 | 272.0 | $>10^{13}$ | 3.4 |
| 7 | $(NH_4)_2Be(SO_4)_2$ | 1.0 | $Be_2C$ | 0.5 | 98 | 251.0 | $>10^{13}$ | 3.4 |
| 8 | $BeSO_4$ | 0.5 | $Be_3N_2$ | 0.5 | 99 | 272.0 | $>10^{13}$ | 3.4 |

0 064 264

**0 064 264**

Example 4

To each silicon carbide powder having the same impurities as described in Example 1 and having an average particle size of 2 μm, each solution obtained by dissolving beryllium acetylacetonate $(Be(CH_3COCHCOCH_3)_2$ in ethanol was added and mixed. The amount of beryllium compound added was 0.1 to 5% by weight in terms of Be basis based on the weight of silicon carbide to give various kinds of the solutions. Further, a xylene solution containing a 25% by weight of silicone resin as a binder was added to each resulting solution in an amount of 10% by weight to give a slurry. The slurry was spray dried to give a powder having a constant particle size, while removing the ethanol and xylene. The resulting powder was molded under a pressure of 98.0 MPa to give a green product. The green product was placed in a graphite die and heated at 1500°C in vacuo ($1.33 \times 10^{-3}$ to $1.33 \times 10^{-1}$ Pa) to pyrolyze the beryllium compound and silicone resin. Subsequently, the pressure was raised to 29.4 MPa and the temperature was also raised to 2050°C and hot pressing was carried out under such conditions for about 1 hour. The pressure was reduced to atmospheric pressure after the temperature became 1500°C or lower.

The thus produced silicon carbide sintered bodies had relative densities of 98% or more, coefficients of thermal expansions of 209.2 to 272.0 W/m·K and electrical resistivities of $10^{12}$ ohm·cm or more.

Example 5

To each silicon carbide powder having the same impurities as described in Example 1 and having a particle size of 0.02 to 0.2 μm, each aqueous solution containing 10% by weight of beryllium nitrate was added in an amount of 5 to 270% by weight (0.036 to 1.8% by weight in terms of the Be basis) based on the weight of silicon carbide and mixed. The water was removed at 150°C to give powders. To 100 g of the resulting powder, 10 ml of a xylene solution containing 25% by weight of silicon resin was added and mixed in a mortar and the resulting mixture was granulated by a conventional method. The granulated powder was molded under a pressure of 98.0 MPa to give a green product. The green product was placed in a furnace and heated at 1500°C in an atmosphere of argon for 1 hour, while pyrolyzing the beryllium nitrate and silicon varnish. Subsequently, the sintering was conducted at 2200°C in an argon atmosphere for 1 hour.

The thus produced silicon carbide sintered bodies had the following properties:

| | |
|---|---|
| Relative density | 93 to 98% |
| Heat conductivity | 188.3 to 251.0 Wm·K |
| Electrical resistivity (at electric field of 10 V/cm) | $10^{12}$ ohm·cm or more |

Example 6

To silicon carbide having the same impurities as described in Example 1 and having an average particle size of 2 μm, various beryllium compounds as shown in Table 4 were added and sintered bodies were produced in the same manner as described in Example 1.

The resulting sintered bodies had properties as shown in Table 4.

As is clear from Table 4, when BeO is added, deviations of the electrical resistivity are large. This tendency is remarkable when the added amount of BeO is small. This seems to be that since the mixing of BeO and silicon carbide is non-uniform, the concentration of Be changes remarkably depending on portions and portions wherein the amount of Be is small make the growth of grains large, which results in reducing the number of grain boundary portions which show high electrical resistivity.

Table 4

| Run No. | Beryllium compound | | | Electrical resistivity (ohm·cm) | | Heat conductivity (W/m·K) | Coefficient of thermal expansion ($\times 10^{-7}/°C$) |
|---------|-------|-----------------|----------------|---------------|------------|---------|---------|
| | Kind | Amount (wt %) | Amount of Be (wt %) | Average value | Deviations | | |
| 1 | BeO | 2 | 0.72 | $7 \times 10^{13}$ | $5 \times 10^{12} - 4 \times 10^{14}$ | 272.0 | 36 |
| 2 | $Be(NO_3)_2$ | 10.6 | 0.72 | $7 \times 10^{13}$ | $3 \times 10^{13} - 5 \times 10^{14}$ | 272.0 | 35 |
| 3 | $Be(OH)_2$ | 3.5 | 0.72 | $6 \times 10^{13}$ | $2 \times 10^{13} - 5 \times 10^{14}$ | 276.1 | 35 |
| 4 | $Be(C_5H_7O_2)_2$ | 16.6 | 0.72 | $6 \times 10^{13}$ | $2 \times 10^{13} - 4 \times 10^{14}$ | 267.8 | 36 |
| 5 | BeO | 0.7 | 0.25 | $5 \times 10^{13}$ | $5 \times 10^{11} - 5 \times 10^{14}$ | 259.4 | 33 |
| 6 | $Be(NO_3)_2$ | 3.7 | 0.25 | $5 \times 10^{13}$ | $1 \times 10^{13} - 4 \times 10^{14}$ | 263.6 | 33 |
| 7 | $Be(OH)_2$ | 1.2 | 0.25 | $4 \times 10^{13}$ | $2 \times 10^{13} - 3 \times 10^{14}$ | 259.4 | 33 |
| 8 | BeO | 0.3 | 0.1 | $3 \times 10^{12}$ | $1 \times 10^{10} - 7 \times 10^{13}$ | 251.0 | 34 |
| 9 | $Be(NO_3)_2$ | 1.5 | 0.1 | $2 \times 10^{13}$ | $5 \times 10^{12} - 1 \times 10^{14}$ | 255.2 | 34 |
| 10 | $Be(OH)_2$ | 0.5 | 0.1 | $1 \times 10^{13}$ | $3 \times 10^{12} - 8 \times 10^{13}$ | 251.0 | 34 |
| 11 | $Be(C_5H_7O_2)_2$ | 2.3 | 0.1 | $8 \times 10^{12}$ | $3 \times 10^{12} - 5 \times 10^{13}$ | 251.0 | 34 |

Note) Run Nos. 1, 5 and 8 are Comparative Examples.

**Claims**

1. A mixture for producing an electrical insulating silicon carbide sintered body, characterized by comprising silicon carbide containing 0.4% by weight or less of free carbon and 0.1% by weight or less of aluminum as impurities as a major component and at least one beryllium compound selected from the group consisting of $Be(OH)_2$, $Be(NO_3)_2$, $BeSO_4$, $BeSO_4$, $\cdot 2NH_3$, $BeCO_3$, $Be(HCO_2)_2$, $Be_4O(HCO_2)_6$, $BeC_2H_4$, $Be_4O(CH_3CO_2)_6$, $(NH_4)_2O \cdot BeO \cdot 2C_2O_3$, $(NH_4)_2Be(SO_4)_2$, and $Be(CH_3COCHCOCH_3)_2$ which can be converted to beryllium, beryllium oxide, beryllium carbide or beryllium nitride by decomposition with heating.

2. A mixture according to Claim 1, wherein the amount of beryllium compound is 0.05 to 7.5% by weight in terms of the amount of beryllium based on the amount of silicon carbide.

3. A mixture according to Claim 1, which further contains a silicone resin as a binder.

4. A process for producing am electrically insulating silicon carbide sintered body, characterized by preparing a mixture comprising silicon carbide containing 0.4% by weight or less of free carbon and 0.1% by weight or less of aluminium as impurities as a major component and at least one beryllium compound selected from the group consisting of $Be(OH)_2$, $Be(NO_3)_2$, $BeSO_4$, $BeSO_4 \cdot 2NH_3$, $BeCO_3$, $Be(HCO_2)_2$, $Be_4O(HCO_2)_6$, $BeC_2H_4$, $Be_4O(CH_3CO_2)_6$, $(NH_4)_2O \cdot BeO \cdot 2C_2O_3$, $(NH_4)_2Be(SO_4)_2$, and $Be(CH_3COCHCOCH_3)_2$ which can be converted to beryllium, beryllium oxide, beryllium carbide or beryllium nitride by decomposition with heating, shaping said mixture into a green product under pressure, and sintering said green product.

5. A process according to Claim 4, wherein the mixture is obtained by dry blending of silicon carbide powder and the beryllium compound powder.

6. A process according to Claim 4, wherein the mixture is obtained by mixing a beryllium compound dissolved in a solvent, said beryllium compound being convertible by decomposition under heating into beryllium, beryllium oxide, beryllium carbide or beryllium nitride, with silicon carbide powder, followed by drying and granulation.

7. A process according to Claim 6, wherein the solvent is water, an organic solvent or an aqueous solution of inorganic material.

8. A process according to Claim 4, wherein the mixture further contains a silicone resin as a binder.

9. A process according to Claim 6, wherein the beryllium compound is $Be(OH)_2$ and the solvent is ethylene-diamine or an aqueous solution of nitric acid or hydrochloric acid.

10. A process according to Claim 6, wherein the beryllium compound is $Be(NO_3)_2$ and the solvent is water or ethanol.

11. A process according to Claim 6, wherein the beryllium compound is $BeCO_3 \cdot 4H_2O$ and the solvent is an aqueous solution of nitric acid or hydrochloric acid or dilute acetic acid.

12. A process according to Claim 6, wherein the beryllium compound is $Be_4O(CH_3CO_2)_6$ and the solvent is acetone or benzene.

13. A process according to Claim 6, wherein the beryllium compound is $Be(CH_3COCHCOCH_3)_2$ and the solvent is ethanol ethyl ether or benzene.

14. A process according to Claim 6, wherein the beryllium compound is $Be(HCO_2)_2$ and the solvent is water.

15. A process according to Claim 6, wherein the beryllium compound is $Be_4O(HCO_2)_6$ and the solvent is acetone or benzene.

16. A process according to Claim 6, wherein the beryllium compound is $BeSO_4$ and the solvent is an aqueous solution of hydrochloric acid.

17. A process according to Claim 4, wherein the green product is heated at a temperature of 1950°C or lower for pyrolyzing the beryllium compound to beryllium, beryllium oxide, beryllium carbide or beryllium nitride prior to sintering.

18. A process according to Claim 17, wherein the green product is heated at a temperature of 1000°C or lower in air.

19. A process according to Claim 4, wherein the sintering is conducted by pressureless sintering.

20. A process according to Claim 4, wherein the sintering is conducted by hot pressing.

**Patentansprüche**

1. Mischung zur Herstellung eines elektrisch isolierenden Siliziumkarbid-Sinterkörpers, dadurch gekennzeichnet, daß sie sich aus Siliziumkarbid, das 0,4 Gew.-% oder weniger freien Kohlenstoff und 0,1 Gew.-% oder weniger Aluminium als Verunreinigungen enthält, als Hauptbestandteil und mindestens einer Berylliumverbindung, ausgewählt aus der Gruppe bestehend aus $Be(OH)_2$, $Be(NO_3)_2$, $BeSO_4$, $BeSO_4 \cdot 2NH_3$, $BeCO_3$, $Be(HCO_2)_2$, $Be_4O(HCO_2)_6$, $BeC_2H_4$, $Be_4O(CH_3CO_2)_6$, $(NH_4)_2O \cdot BeO \cdot 2C_2O_3$, $(NH_4)_2Be(SO_4)_2$, und $Be(CH_3COCHCOCH_3)_2$, die durch Zersetzung unter Erhitzen in Beryllium, Berylliumoxid, Berylliumkarbid oder Berylliumnitrid umgewandelt werden kann, zusammensetzt.

2. Mischung nach Anspruch 1, worin die Menge der Berylliumverbindung 0,05 bis 7,5 Gew.-%, ausgedrückt als Berylliummenge, basierend auf der Menge an Siliziumkarbid, beträgt.

3. Mischung nach Anspruch 1, die außerdem ein Siliconharz als Bindemittel enthält.

4. Verfahren zur Herstellung eines elektrisch isolierenden Siliziumkarbid-Sinterkörpers, gekennzeichnet durch Herstellen einer Mischung aus Siliziumkarbid, das 0,4 Gew.-% oder weniger freien Kohlenstoff und 0,1 Gew.-% oder weniger Aluminium als Verunreinigungen enthält, als Hauptbestandteil und mindestens einer Berylliumverbindung, ausgewählt aus der Gruppe bestehend aus $Be(OH)_2$, $Be(NO_3)_2$, $BeSO_4$, $BeSO_4 \cdot 2NH_3$, $BeCO_3$, $Be(HCO_2)_2$, $Be_4O(HCO_2)_6$, $BeC_2H_4$, $Be_4O(CH_3CO_2)_6$, $(NH_4)_2O \cdot BeO \cdot 2C_2O_3$, $(NH_4)_2Be(SO_4)_2$, und $Be(CH_3COCHCOCH_3)_2$, die durch Zersetzung unter Erhitzen in Beryllium, Berylliumoxid, Berylliumkarbid oder Berylliumnitrid umgewandelt werden kann, Formen der Mischung unter Druck zu einem grünen Produkt und Sintern des grünen Produkts.

5. Verfahren nach Anspruch 4, wobei die Mischung durch Trockenmischen von Siliziumkarbidpulver und Pulver der Berylliumverbindung erhalten wird.

6. Verfahren nach Anspruch 4, wobei die Mischung durch Mischen einer in einen Lösungsmittel gelösten Berylliumverbindung, die durch Zersetzung unter Erhitzen in Beryllium, Berylliumoxid, Berylliumkarbid oder Berylliumnitrid umgewandelt werden kann, mit Siliziumkarbidpulver und anschließendes Trocknen und Granulieren erhalten wird.

7. Verfahren nach Anspruch 6, wobei das Lösungsmittel Wasser, ein organisches Lösungsmittel oder eine wässrige Lösung eines anorganischen Materials ist.

8. Verfahren nach Anspruch 4, wobei die Mischung zusätzlich ein Siliconharz als Bindemittel enthält.

9. Verfahren nach Anspruch 6, wobei die Berylliumverbindung $Be(OH)_2$ und das Lösungsmittel Ethylendiamin oder eine wässrige Salpetersäure-oder Salzsäurelösung ist.

10. Verfahren nach Anspruch 6, wobei die Berylliumverbindung $Be(NO_3)_2$ und das Lösungsmittel Wasser oder Ethanol ist.

11. Verfahren nach Anspruch 6, wobei die Berylliumverbindung $BeCO_3 \cdot 4H_2O$ und das Lösungsmittel eine wässrige Salpetersäure-, Salzsäure- oder verdünnte Essigsäurelösung ist.

12. Verfahren nach Anspruch 6, wobei die Berylliumverbindung $Be_4O(CH_3CO_2)_6$ und das Lösungsmittel Aceton oder Benzol ist.

13. Verfahren nach Anspruch 6, wobei die Berylliumverbindung $Be(CH_3COCHCOCH_3)_2$ und das Lösungsmittel Ethanol, Ethylether oder Benzol ist.

14. Verfahren nach Anspruch 6, wobei die Berylliumverbindung $Be(HCO_2)_2$ und das Lösungsmittel Wasser ist.

15. Verfahren nach Anspruch 6, wobei die Berylliumverbindung $Be_4O(HCO_2)_6$ und das Lösungsmittel Aceton oder Benzol ist.

16. Verfahren nach Anspruch 6, wobei die Berylliumverbindung $BeSO_4$ und das Lösungsmittel eine wässrige Salzsäurelösung ist.

17. Verfahren nach Anspruch 4, wobei das grüne Produkt auf eine Temperatur von 1950°C oder niedriger zum Pyrolysieren der Berylliumverbindung zu Beryllium, Berylliumoxid, Berylliumkarbid oder Berylliumnitrid vor dem Sinteren erhitzt wird.

18. Verfahren nach Anspruch 17, wobei das grüne Produkt auf eine Temperatur von 1000°C oder niedriger in Luft erhitzt wird.

19. Verfahren nach Anspruch 4, wobei das Sintern durch druckloses Sintern durchgeführt wird.

20. Verfahren nach Anspruch 4, wobei das Sintern durch Heißpressen durchgeführt wird.

**Revendications**

1. Mélange pour la fabrication d'un corps fritté en carbure de silicium, isolant électrique, caractérisé en ce qu'il comprend, en tant que composant principal, du carbure de silicium contenant 0,4% en poids ou moins de carbone libre et 0,1% en poids ou moins d'aluminium, comme impuretés, et au moins un composé du beryllium choisi dans le groupe constitué de $Be(OH)_2$, $Be(NO_3)_2$, $BeSO_4$, $BeSO_4 \cdot 2NH_3$, $BeCO_3$, $Be(HCO_2)_2$, $Be_4O(HCO_2)_6$, $BeC_2H_4$, $Be_4O(CH_3CO_2)_6$, $(NH_4)_2O \cdot BeO \cdot 2C_2O_3$, $(NH_4(_2Be(SO_4)_2$, et $Be(CH_3COCHCOCH_3)_2$, qui peut être converti en beryllium, oxide der beryllium, carbure de beryllium ou nitrure de beryllium, par décomposition thermique.

2. Melangé selon la revendication 1, dans lequel la quantité de composé de beryllium est de 0,05 à 7,5% en poids, exprimé en quantité de beryllium par rapport à la quantité de carbure de silicium.

3. Mélange selon la revendication 1, qui contient en outre une résine de silicone en tant que liant.

4. Procédé pour la fabrication d'un corps fritté en carbure de silicium, isolant électrique, caractérisé en ce que l'on prépare un mélange comprenant, en tant que composant principal, du carbure de silicium contenant 0,4% en poids ou moins de carbone libre et 0,1% en poids ou moins d'aluminium, comme impuretés, et au moins un composé de beryllium choisi dans le groupe constitué de $Be(OH)_2$, $Be(NO_3)_2$, $BeSO_4$, $BeSO_4 \cdot 2NH_3$, $BeCO_3$, $Be(HCO_2)_2$, $Be_4O(HCO_2)_6$, $BeC_2H_4$, $Be_4O(CH_3CO_2)_6$, $(NH_4)_2O \cdot BeO \cdot 2C_2O_3$, $(NH_4)_2Be(SO_4)_2$, et $Be(CH_3COCHCOCH_3)_2$, qui peut être converti en beryllium, oxyde de beryllium, carbure de beryllium ou nitrure de beryllium, par décomposition thermique que l'on forme sous pression ledit mélange en un produit vert, et que l'on fritte ledit produit vert.

5. Procédé selon la revendication 4, dans lequel le mélange est obtenu en mélangeant à sec le carbure de silicium en poudre et le composé du beryllium en poudre.

6. Procédé selon la revendication 4, dans lequel le mélange est obtenu en mélangeant un composé du beryllium qui est dissous dans un solvant et qui peut être converti en beryllium, oxyde de beryllium, carbure de beryllium ou nitrure de beryllium par décomposition thermique, avec le carbure de silicium en poudre, suivi d'un séchage et d'une granulation.

7. Procédé selon la revendication 6, dans lequel le solvant est de l'eau, un solvant organique ou une solution aqueuse d'un composé minéral.

8. Procédé selon la revendication 4, dans lequel le mélange contient en outre une résine de silicone en tant que liant.

9. Procédé selon la revendication 6, dans lequel le composé de beryllium est $Be(OH)_2$, et la solvant est l'éthylène-diamine ou une solution aqueuse d'acide nitrique ou d'acide chlorhydrique.

10. Procédé selon la revendication 6, dans lequel le composé de beryllium est $Be(NO_3)_2$, et le solvant est leau ou l'éthanol.

11. Procédé selon la revendication 6, dans lequel le composé de beryllium est $BeCO_3 \cdot 4H_2O$ et le solvant est une solution aqueuese d'acide nitrique ou d'acide chlorhydrique ou d'acide acétique dilué.

12. Procédé selon la revendication 6, dans lequel le composé de beryllium est $Be_4O(CH_3CO_2)$, et le solvant est l'acétone ou le benzène.

13. Procédé selon la revendication 6, dans lequel le composé de beryllium est $Be(CH_3COCHCOCH_3)_2$ et le solvant est l'ethanol, l'éther éthylique ou le benzène.

14. Procédé selon la revendication 6, dans lequel le composé de beryllium est $Be(HCO_2)_2$ et le solvant est l'eau.

15. Procédé selon la revendication 6, dans lequel le composé de beryllium est $Be_4O(HCO_2)_6$ et le solvant est l'acetone ou le benzène.

16. Procédé selon la revendication 6, dans lequel le composé de beryllium est $BeSO_4$ et la solvant est une solution aqueuse d'acide chlorhydrique.

17. Procédé selon la revendication 4, dans lequel le produit vert est chauffé à une température de 1950°C ou moins pour la pyrolyse de composé du beryllium en beryllium, oxyde de beryllium, carbure de beryllium ou nitrure de beryllium, avant le frittage.

18. Procédé selon la revendication 17, dans lequel le produit vert est chauffé à une température de 1000°C ou moins dans l'air.

19. Procédé selon la revendication 4, dans lequel le frittage est effectué par frittage sans pression.

20. Procédé selon la revendication 4, dans lequel le frittage est effectué par pression à chaud.

14